(19) Europäisches Patentamt
European Patent Office
Office européen des brevets

(11) **EP 1 168 606 A2**

(12) **EUROPÄISCHE PATENTANMELDUNG**

(43) Veröffentlichungstag:
**02.01.2002 Patentblatt 2002/01**

(51) Int Cl.7: **H03G 5/00**

(21) Anmeldenummer: **01305207.1**

(22) Anmeldetag: **15.06.2001**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **21.06.2000 DE 10030583**

(71) Anmelder: **Marconi Communications GmbH**
**71520 Backnang (DE)**

(72) Erfinder:
• **Muller, Jorg-Martin**
**70619 Stuttgart (DE)**
• **Helmke, Holger**
**71522 Backnang (DE)**

(74) Vertreter: **Webb, Peter Reginald**
**Marconi Intellectual Property Marrable House**
**The Vineyards Gt. Baddow**
**Chelmsford Essex CM2 7QS (GB)**

(54) **Vorrichtung und Verfahren zum Verabeiten von Hochfrequenzsignalen**

(57) Die Erfindung betrifft eine Vorrichtung zum Verarbeiten von Frequenzsignalen mit einem Leistungsbegrenzer (10), wobei der Leistungsbegrenzer (10) einen ersten Signalweg (12) aufweist, der Leistungsbegrenzer (10) einen zweiten Signalweg (14) aufweist, der erste Signalweg (12) Mittel (16) zur analogen Signalverarbeitung aufweist, der zweite Signalweg (14) Mittel (18) zur digitalen Signalverarbeitung aufweist, die Mittel (18) zur digitalen Signalverarbeitung Mittel zum selektiven Unterdrücken bestimmter Frequenzbereiche aufweisen und ein Ausgang des ersten Signalwegs (12) und ein Ausgang des zweiten Signalwegs (14) mit Mitteln (22) zum Kombinieren von Signalen verbunden sind. Die Erfindung betrifft ferner ein Verfahren, welches vorteilhaft mit der erfindungsgemäßen Vorrichtung ausführbar ist.

Fig.1

EP 1 168 606 A2

**Beschreibung**

Die vorliegende Erfindung betrifft eine Vorrichtung zum Verarbeiten von Frequenzsignalen mit einem Leistungsbegrenzer. Die Erfindung betrifft ferner ein Verfahren zum Verarbeiten von Frequenzsignalen, bei dem eine Leistung begrenzt wird.

**Stand der Technik**

Auf dem Gebiet moderner Funksysteme sind beispielsweise digitale Mehrpunktsysteme ("digital multipoint systems" (DMS)) bekannt. Ein DMS-Frequenzband besteht aus einer Vielzahl von Frequenzkanälen. Bei einem DMS-26 GHz existieren beispielsweise 32 Kanäle mit je 28 MHz. Im Allgemeinen erhält ein DMS-Betreiber von der Regulierungsbe-hörde die Erlaubnis, seine Dienste in einem oder in mehreren zusammenhängenden oder auch nicht zusammenhängenden Kanälen anzubieten. Der Hersteller muss daher die Radio-frequenzmodule (RF) von Basisstation und Endstelle bei der Produktion auf diese Kanäle abstimmen. Dies führt zu einem hohen Entwicklungsaufwand, da mehrere kanalspezifische RF-Module entwickelt werden müssen. Ferner entsteht ein Mehraufwand bei der Produktion, beispielsweise aufgrund erhöhter Lagerhaltungskosten, da jeder Kanal spezifische Bauelemente erfordert.

Im Folgenden wird die konventionelle breitbandige Abtastung beschrieben. Bei gegebener Auflösung beziehungsweise Dynamik der in den Systemen eingesetzten Analog-Digital-Wandler sind die vorgeschalteten analogen Filter so auszulegen, dass eine Sättigung der Wandler auch bei extremen Betriebsbedingungen ("Worst Case") vermieden wird. Da die Quantisierungsrauschleistungsdichte eines Analog-Digital-Wandlers konstant ist, ist eine Dämpfung des Analogsignales zur Vermeidung der Sättigung ohne signifikante Verschlechterung des Signal-zu-Rauschabstandes (SNR) des Nutzkanales nicht möglich. Bei breitbandiger Abtastung besteht die Gefahr, dass auch Frequenzanteile gewandelt werden, die von fremden Systemen stammen und auf deren Leistungsdichte kein Einfluss genommen werden kann. Bei einem DMS-System ist dies beispielsweise dann der Fall, wenn ein Nachbarkanal einem anderen Betreiber gehört.

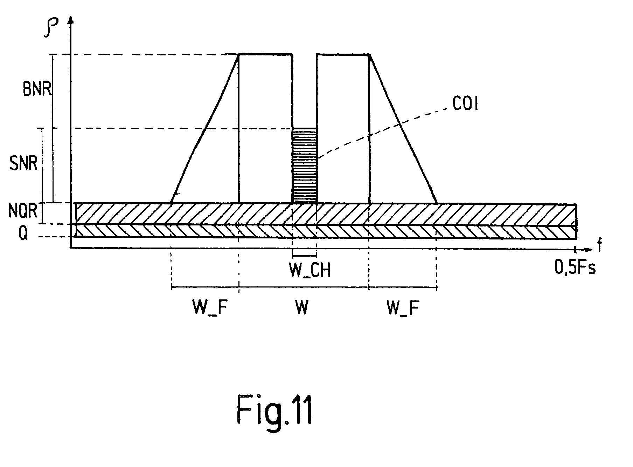

In Figur 11 ist ein Szenario für die Worst-Case-Leistungsdichteverteilung am Eingang eines breitbandigen Analog-Digital-Wandlers bei einem DMS-System dargestellt. In dem Diagramm ist die Leistungsdichte $\rho$ gegen die Frequenz f aufgetragen. Im Zentrum der Leistungsdichteverteilung befindet sich der interessierende Kanal ("channel of interest" (COI)). Im Rahmen der vorliegenden Darstellung wird angenommen, dass alle Nachbarkanäle mit einer konstanten Leistungsdichte von BNR [dB] ("Blocking to Noise Ratio") und der Nutzkanal mit einer Leistungsdichte von SNR [dB] ("Signal to Noise Ratio") über dem Rauschpegel der analogen Verarbeitungskette am Eingang des Analog-Digital-Wandlers anliegen. Dabei kann die Leistungsdichte der Nachbarkanäle bis zu 30 dB über der des Nutzkanales liegen, falls diese Kanäle einem anderen Betreiber gehören. Folglich gilt im Worst Case:

$$BNR_{max} = SNR + 30 \text{ dB} \qquad (1)$$

Durch Berechnung der Gesamtleistung aus dem Modell nach Figur 11 und der Forderung, dass diese Leistung kleiner sein muss als die Spitzenleistung eines Analog-Digital-Wandlers mit einer effektiven Auflösung von ADC Bit, kann eine Bedingung für das maximale BNR abgeleitet werden, für das der Wandler noch nicht in der Sättigung betrieben wird:

$$BNR \le 10 \cdot \lg\left(\frac{3 \cdot 2^{2(ADC-1)} \cdot 10^{\frac{Cr+NQR}{10}} - \frac{W_{CH}}{f_S} \cdot 10^{\frac{SNR}{10}} + \frac{2 \cdot W_F + W}{f_S} - \frac{1}{2}}{\frac{W_F + W - W_{CH}}{f_S}}\right) \qquad (2)$$

mit

SNR =     "Signal to Noise Ratio" des Nutzkanals in [dB]
BNR =     "Blocking to Noise Ratio" der Nachbarkanäle in [dB]

CR = Crest Faktor in [dB]

NQR = Abstand zwischen Quantisierungsrauschleistungdichte Q und Signalrauschleistungsdichte in [dB]

$f_s$ = Abtastfrequenz

ADC = Anzahl der effektiven Bits des Analog-Digital-Wandlers

$W_{CH}$ = Bandbreite eines Nutzkanals

W = Gesamte Nutzbandbreite am Eingang des Analog-Digital-Wandlers

$W_F$ = Bandbreite der Filterflanke des analogen Anti-Aliaising Filters

Die obige Gleichung (2) wird anhand von 2 Beispielen erläutert.

Beispiel 1: Es wird eine Wandlung von 2 Kanälen bei einem 26 GHz-System beschrieben.

Das Kanalraster ist $W_{CH}$ = 28 MHz. Es sollen gleichzeitig zwei dieser Kanäle mit einem Analog-Digital-Wandler verarbeitet werden (W = 56 MHz). Die Abtastfrequenz betrage $f_S \cong$ 200 MHz. Das maximal vorkommende SNR des Nutzkanals liege bei SNR $\cong$ 17 dB. Als Analog-Digital-Wandler wird ein Wandler mit einer effektiven Anzahl von Bits mit ADC = 9 angenommen. Die Übergangsbandbreite der analogen Filter betrage $W_F$ = 0,25 W = 14 MHz. Der Crestfaktor (Eingangs-Spitzenamplitude zu mittlerer Amplitude) wird zu CR = 10 dB angenommen.

Außerdem soll gefordert werden, dass die maximal zulässige SNR Degradation aufgrund der Analog-Digital-Wandlung $\Delta$ = 0,5 dB betragen soll. Daraus ergibt sich der Abstand von Quantisierungsrauschleistungs- und Signalrauschleistungsdichte zu

$$NQR = -10 \cdot \lg\left( 10^{\frac{\Delta}{10}} + 1 \right) \approx 9dB \qquad (3)$$

Nach Gleichung (3) erhält man ein maximal zulässiges BNR von

BNR < 41 dB [gefordert: BNR = 47 dB]

Die Leistungsdichte des Nachbarkanales darf also um 24 dB über der Leistungsdichte des Nutzkanales liegen. Die 30 dB Forderung kann daher nicht eingehalten werden, und unter ungünstigen Bedingungen kann es zu einer Übersteuerung des Wandlers kommen, so dass eine Dynamikreduktion durch kanalspezifische analoge Vorfilter notwendig wird.

Beispiel 2: Es wird die Wandlung von vier Kanälen bei DMS-26 GHz beschrieben.

Bei einem Kanalraster von $W_{CH}$ = 28 MHz werden nun vier Kanäle mit einem Analog-Digital-Wandler verarbeitet (W = 122 MHz). Die Abtastfrequenz soll $f_S \cong$ 200 MHz betragen. Das maximal vorkommende SNR des Nutzkanals wird wie oben mit SNR = 17 dB angesetzt. Als Analog-Digital-Wandler soll ein Wandler mit ADC = 7 angenommen. Die Übergangsbandbreite der analogen Filter betrage $W_F$ = 0,25 W = 28 MHz. Der Crestfaktor sei Cr = 10 dB.

Damit erhält man bei einer zulässigen SNR Degradation aufgrund der Analog-Digital-Wandlung von $\Delta$ = 0,5 dB aus obiger Gleichung ein maximal zulässiges BNR von

BNR < 27 dB [gefordert: BNR = 47 dB] (4)

Die Leistungsdichte der drei Nachbarkanäle darf also nur 10 dB über der Leistungsdichte des Nutzkanales liegen. Für einen Einsatz bei DMS ist diese konventionelle Lösung deshalb völlig ungeeignet. Um die 30 dB Forderung mit Reserven erfüllen zu können, müsste ein 400 MHz Analog-Digital-Wandler mit einer effektiven Auflösung von 12 Bit (ca. 14 Bit nominal) zur Verfügung stehen, was zur Zeit (1998) nicht absehbar ist. Um eine Übersteuerung des Wandlers zu vermeiden müsste die Signalleistung um mindestens 20 dB reduziert werden.

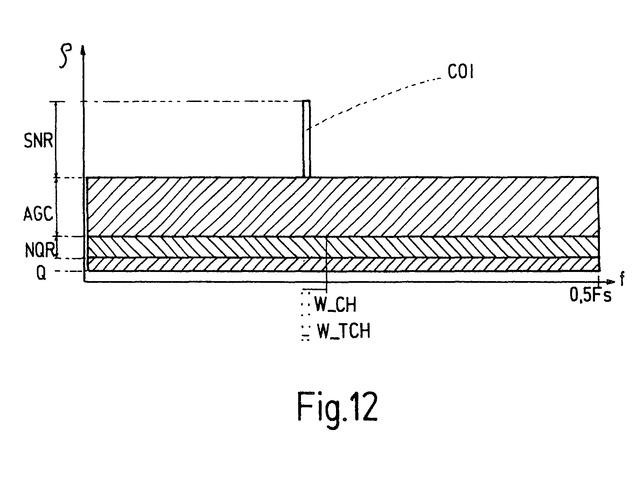

Vorstehend wurde das Szenario maximaler Last ("Maximum Load Szenario") beschrieben. Neben diesem muss auch das Szenario minimaler Last ("Minimum Load Szenario") untersucht werden. Hierzu wird auf Figur 12 verwiesen. In diesem Fall steht am Eingang des Wandlers nur die Signalleistung eines Verkehrskanals (Traffic Channel, Sub-Channel) mit einer Bandbreite von z.B. 80 kHz (DMS) und einem SNR von 5 dB (QPSK), so dass der Wandler kaum noch ausgesteuert wird. Dies bewirkt zusammen mit dem sehr hohen Überabtastfaktor (Abtastfrequenz/Nutzkanalbandbreite) eine starke Korrelation von Signal und Quantisierungsrauschen und damit eine signifikante Verschlechterung des SNR.

Diesem Effekt kann begegnet werden, indem die Eingangsleistung beispielsweise durch eine automatische Verstärkungssteuerung ("Automatic Gain Control" (AGC)) erhöht wird. Bedingungen für weißes Quantisierungsrauschen lassen sich analytisch und durch Simulation angeben.

Die für den Überabtastfaktor relevante Bandbreite ist aufgrund der breitbandigen analogen Vorverarbeitung und damit der großen Rauschbandbreite $W_{noise} = W$.

Damit ist der Überabtastfaktor für die Beispiele 1 und 2:

$$\eta = \frac{f_S}{W} \approx 2^2 \tag{5}$$

Die Ergebnisse zeigen, dass bei Erfüllung der Bedingung

$$10 \cdot \lg\left(\frac{\sigma^2}{\delta^2}\right) = 10 \cdot \lg\left(\frac{1}{6} \cdot 10^{\frac{NQR+AGC}{10}}\right) > 0\text{dB} \tag{6}$$

das Quantisierungsrauschen für diesen Überabtastfaktoren annähernd weiß ist. Mit $\sigma^2$ wird die mittlere Signalleistung und mit $\delta$ die Quantisierungsschrittweite des eingesetzten Wandlers bezeichnet.

Damit erhält man die Bedingung

$$AGC > 8 \text{ dB - NQR} \tag{7}$$

Bei einem NQR von mehr als 8 dB, was sicherlich immer der Fall sein wird, ist eine AGC deshalb nicht notwendig.

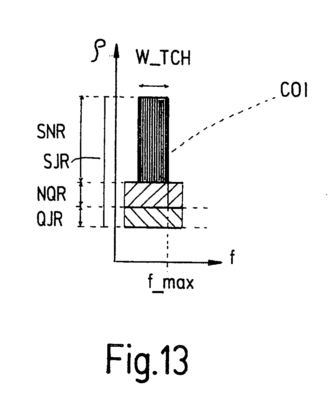

Ein wichtiger Parameter für die Auslegung des Abtastsystems ist die zulässige Abweichung des Abtastzeitpunktes von seinem Nominalwert (Abtastjitter). Um die Varianz des Taktjitters quantitativ zu erfassen wird auf das Modell gemäß Figur 13 Bezug genommen. Im Rahmen dieses Modells wird angenommen, dass die Jitterrauschleistung, die zum Beispiel von einem Kanal erzeugt wird, spektral auf diesen begrenzt ist.

Folgende Gleichung gibt eine Bedingung für die Varianz des Taktjitters in Abhängigkeit von der Auflösung des verwendeten Wandlers, der Nutzkanalbandbreite sowie des geforderten Abstandes zwischen Quantisierungs- und Jitterrauschleistungsdichte an.

$$\Delta = 10 \cdot \lg\left(10^{\frac{SJR-SNR}{10}} + 10^{\frac{NQR}{10}} + 1\right) = 10 \cdot \lg\left(10^{\frac{NQR}{10}} \cdot \left(10^{\frac{QJR}{10}} + 1\right) + 1\right) \tag{8}$$

mit

SJR =   $-20 \cdot \lg(2 \cdot \pi \cdot f_{max} \cdot \sigma_j)$

mit

$\sigma_j$ =        Varianz des Jitters des Abtasttaktes in [sec]
SNR =     "Signal to Noise Ratio" des Nutzkanals in [dB]
NQR =     Abstand zwischen Signal- und Quantisierungsrauschleistungsdichte in [dB]

QJR = Abstand zwischen Quantisierungs- und Jitterrauschleistungsdichte in [dB]

SJR = Abstand zwischen Signal- und Taktjitter-Rauschleistungsdichte in [dB]

$f_{max}$ = Maximale Signalfrequenz

Die Forderungen an die Varianz des Taktjitters werden nachfolgend an zwei Beispielen erläutert.

Beispiel 1: Es wird die Wandlung von zwei Kanälen bei 26 GHz beschrieben.

Die schärfste Bedingung gilt für den zweiten 28 MHz Kanal, also $f_{max}$ = 68 MHz. Damit der erste Term in der inneren Klammer von Gleichung 2 keinen signifikanten Beitrag zur SNR Degradation liefert, sei gefordert:

$$QJR > 10 \text{ dB} \tag{9}$$

Mit SNR = 17 dB und NQR = 9 dB ergibt sich eine Anforderung an den Jitter von:

$$\sigma_j \leq 37 \text{ psec} \tag{10}$$

Beispiel 2: Es wird die Wandlung von vier Kanälen bei 26 GHz betrachtet.

Die schärfste Bedingung gilt für den vierten 28 MHz Kanal, also $f_{max}$ = 136 MHz.

Mit den Zahlen aus Beispiel 1 erhält man die Forderung:

$$\sigma_j \leq 18,5 \text{ psec} \tag{11}$$

Die vorstehenden Ausführungen zeigen, dass bei einer konventionellen breitbandigen Abtastung (beispielsweise vier 28 MHz-Kanäle bei 26 GHz, ein Analog-Digital-Wandler mit einer effektiven Auflösung von mindestens 12 Bit (14 Bit nominal) bei einer Abtastfrequenz von mehr als 400 MHz erforderlich ist. Nur bei einer solchen Wandlerdynamik sind Signalleistungen, die in Nachbarkanälen von fremden Systemen empfangen werden, beherrschbar. Die Bereitstellung derartiger Wandler erscheint in absehbarer Zukunft ausgeschlossen.

Um mit heutigen Wandlern eine breitbandige Abtastung vornehmen zu können, muss das Signal vor der Wandlung in seiner Leistung begrenzt werden. Dies kann herkömmlich durch kanalspezifische analoge Filter geschehen, was allerdings das bereits erwähnte Problem mit sich bringt, dass die Filter kanalspezifisch ausgelegt werden müssen.

### Vorteile der Erfindung

Die Erfindung baut auf dem Stand der Technik gemäß Anspruch 1 dadurch auf, dass der Leistungsbegrenzer einen ersten Signalweg aufweist, dass der Leistungsbegrenzer einen zweiten Signalweg aufweist, dass der erste Signalweg Mittel zur analogen Signalverarbeitung aufweist, dass der zweite Signalweg Mittel zur digitalen Signalverarbeitung aufweist, dass die Mittel zur digitalen Signalverarbeitung Mittel zum selektiven Unterdrücken bestimmter Frequenzbereiche aufweisen und dass ein Ausgang des ersten Signalweges und ein Ausgang des zweiten Signalweges mit Mitteln zum Kombinieren von Signalen verbunden sind. Mit dieser Anordnung gelingt es, die Leistung in allen dem Nutzkanal benachbarten Kanälen zu reduzieren. Konfiguriert und gesteuert wird diese Anordnung vom Digitalteil, womit sie an den zu prozessierenden Nutzkanal anpassbar ist. Im vorliegenden Zusammenhang wird unter Nutzkanal der gesamte in einer Basisstation zu verarbeitende Frequenzbereich verstanden werden. Bei 26 GHz-Systemen könnten dies beispielsweise ein oder mehrere benachbarte oder nicht benachbarte 28 MHz-Kanäle sein.

Bevorzugt weist der zweite Signalweg einen Analog-Digital-Wandler, ein FIR-Filter ("Finite Impulse Response" (FIR)) und einen Digital-Analog-Wandler auf. Auf diese Weise wird durch das Leistungsbegrenzungsmodul ein kausales Komplementärfilter zur Verfügung gestellt, dessen Filterteil digital ausgeführt ist. Auf dem zweiten Signalweg wird der Nutzkanal mittels eines FIR-Filters unterdrückt, während die Nachbarkanäle mit möglichst hohem SNR prozessiert werden. Das gefilterte Signal wird nachfolgend zur weiteren Verarbeitung einem Digital-Analog-Wandler zugeführt.

Vorzugsweise ist in dem FIR-Filter eine Leistungseinstellung, eine Verzögerungseinstellung und eine si(x)-Kompensation durchführbar. Folglich kann das digitale Signal so aufbereitet werden, dass nachfolgend durch die Kombination mit dem über den ersten Signalweg geleiteten Analogsignal ein Signal entsteht, bei welchem das Nutzband unverändert übertragen wird, während die Nachbarkanäle unterdrückt sind.

In diesem Zusammenhang ist es vorteilhaft, dass das FIR-Filter steile Filterflanken aufweist. Hierdurch gelingt es, die Signalleistung unmittelbar neben dem Nutzkanal effizient zu unterdrücken, was zu einem hohen Grad (N > 150) führt.

Es ist bevorzugt, dass das FIR-Filter bei der Abtastrate der Wandler arbeitet. Es kann also ohne Abtastratenreduktion gearbeitet werden.

Es kann nützlich sein, dass das FIR-Filter mittels einer Filterbank realisiert ist. Man arbeitet also mit mehreren Analysefiltern, wobei jedes ein Bandpass-FIR-Filter für einen Kanal prozessiert; gleichzeitig wird die Abtastrate reduziert. Bei vier Analysefiltern arbeitet jedes der Filter bei einem Viertel der Abtastrate. Durch die Ausblendung des Teilbands des Nutzkanals wird die erwünschte Bandsperrencharakteristik erzeugt. Die anderen Teilbänder können für die nachfolgende Synthesefilterung aufgearbeitet werden. Nach der Synthesefilterung kann eine Addition der Teilbandsignale mit der hohen Abtastfrequenz erfolgen.

Bevorzugt weist der erste Signalweg ein analoges Verzögerungsglied auf. Hierdurch erreicht man, dass die Verzögerungen auf dem ersten Signalweg und dem zweiten Signalweg übereinstimmen, wodurch eine Verminderung der Filterwirkung vermieden wird.

Besonders bevorzugt ist es, wenn das analoge Verzögerungsglied eine konstante Gruppenlaufzeit aufweist. Diese Konstanz der Gruppenlaufzeit über einen Frequenzbereich zwischen beispielsweise 20 und 150 MHz ermöglicht eine gute Filterwirkung über den genannten großen Frequenzbereich. Eine realistische konstante Gruppenlaufzeit liegt beispielsweise im Bereich von 250 ns.

Besonders zu bevorzugen ist, dass die konstante Gruppenlaufzeit der Gesamtverzögerung der Wandler und des FIR-Filters des zweiten Signalweges entspricht. Somit ist die Verzögerung des analogen Verzögerungsgliedes an die Verzögerung des zweiten Signalpfades angepasst.

Bevorzugt weisen die Mittel zum Kombinieren von Signalen einen analogen Addierer auf. Mit einer derartigen Vorrichtung lassen sich Signale der beiden Signalwege voneinander subtrahieren, so dass das resultierende Signal ein quasi unverändertes Nutzband hat, während die Nachbarkanäle unterdrückt sind.

Vorzugsweise ist das Ausgangssignal des analogen Addierers einem Analog-Digital-Wandlermodul zuführbar. Die eigentliche Analog-Digital-Wandlung erfolgt daher auf der Grundlage eines Eingangssignals, bei welchem die störenden Nachbarkanäle unterdrückt sind.

Es ist nützlich, wenn das Eingangsfrequenzsignal Mitteln zur analogen Vorverarbeitung zuführbar ist. Auf diese Weise kann das analoge Eingangssignal durch die analoge Vorverarbeitung soweit gedämpft werden, dass der Wandler auf dem zweiten Signalweg nicht übersteuert wird. Dies ist vorteilhaft, da durch die Wandler auf dem zweiten Signalweg Rauschen entsteht, welches zu dem Originalsignal unkorreliert ist und welches daher auch nicht unterdrückt werden kann. Die Leistungsdichte dieses Rauschbeitrages muss folglich möglichst klein sein (hohes SNR der Nachbarkanäle).

Vorzugsweise ist dem Eingangsfrequenzsignal ein Kalibrierungssignal einspeisbar. Dieses Kalibrierungssignal, welches "außerhalb" des Nutzsignals liegt, wird im Digitalteil (Modem) hinter dem Analog-Digital-Wandlermodul ausgewertet. Die Regelung der digitalen Verzögerung kann auf dieser Grundlage erfolgen, und zwar so, dass die Unterdrückung des Kalibrierungssignal maximal ist. Da im Digitalteil die Möglichkeit besteht die Verzögerung adaptiv einzustellen, beispielsweise durch das Zuschalten von Verzögerungsgliedern, besteht für den Analogteil nicht die Notwendigkeit, die Verzögerung absolut einzustellen. Solange diese nur in derselben Größenordnung liegt, ist es möglich, den ersten Signalweg und den zweiten Signalweg aufeinander abzustimmen. Allerdings sollte darauf geachtet werden, dass die Gruppenlaufzeit der analogen Verzögerung über den gesamten interessierenden Frequenzbereich konstant ist.

In einer weiteren Ausführungsform kann es vorteilhaft sein, dass ein dritter Signalweg vorgesehen ist, welcher digital einen äquivalenten Kanal realisiert, in welchem eine Abtastratenreduzierung erfolgt, wobei der dritte Signalweg einen komplexen Mischer und ein FIR-Filter aufweist. Hierdurch kann auf eine Bandsperrenfilterung des Nutzbandes auf dem zweiten Signalweg verzichtet werden. Auf diese Weise können die Filteranforderungen an das FIR-Filter drastisch verringert werden. Dementsprechend reicht es aus, wenn das analoge Verzögerungsglied eine nur sehr viel kleinere Verzögerung realisiert, welche etwa um einen Faktor 16 niedriger liegt als bei der Ausführungsform mit Bandsperrenfilterung. Das FIR-Filter auf dem zweiten Signalweg führt daher beispielsweise lediglich eine si(x)-Kompensation, eine Verzögerungseinstellung und eine Leistungseinstellung durch.

Vorzugsweise ist das Ausgangssignal des Analog-Digital-Wandlermoduls einem vierten Signalweg zuführbar, in welchem eine Abtastratenreduktion erfolgt, wobei der vierte Signalweg einen komplexen Mischer und ein FIR-Filter aufweist. Damit wird das Ausgangssignal des Analog-Digital-Wandlermoduls dem Signal des dritten Signalwegs angepasst.

In diesem Zusammenhang ist es dann vorteilhaft, wenn ein Ausgang des dritten Signalwegs und ein Ausgang des vierten Signalwegs mit Mitteln zum Kombinieren von Signalen verbunden sind. Durch den Übergang zu einem äquivalenten komplexen Tiefpasssignal und die nachfolgende Kombination der Signale des dritten Signalwegs und des vierten Signalwegs kann somit eine Abtastratenreduzierung, beispielsweise um den Faktor 8 durchgeführt werden.

Es kann nützlich sein, dass das Ausgangssignal des Analog-Digital-Wandlermoduls über eine Kalibrierungseinheit auf mindestens ein FIR-Filter rückgekoppelt ist. Die Effekte des jeweiligen FIR-Filters lassen sich also auf der Grundlage des Ausgangssignals des Analog-Digital-Wandlermoduls einstellen.

Ebenso kann es im selben Zusammenhang nützlich sein, dass das Ausgangssignal des Analog-Digital-Wandlermoduls über eine Kalibrierungseinheit auf einen einstellbaren Verstärker des Analog-Digital-Wandlermoduls rückkoppelbar ist. Die Verstärkung lässt sich also in Abhängigkeit der Amplituden- und Phasengänge im Nutzband anpassen.

Die Erfindung baut auf dem gattungsgemäßen Verfahren gemäß Anspruch 19 dadurch auf, dass das Frequenzsignal einem ersten Signalweg zugeführt wird, das Frequenzsignal einem zweiten Signalweg zugeführt wird, dass in dem ersten Signalweg eine analoge Signalverarbeitung stattfindet, und dass in dem zweiten Signalweg eine digitale Signalverarbeitung stattfindet, dass bei der digitalen Signalverarbeitung bestimmte Frequenzbereiche selektiv unterdrückt werden und dass ein Signal, welches aus der analogen Signalverarbeitung resultiert, mit einem Signal, welches aus der digitalen Signalverarbeitung resultiert, kombiniert wird. Durch dieses Verfahren werden die Vorteile der erfindungsgemäßen Vorrichtung umgesetzt.

Vorzugsweise wird in dem zweiten Signalweg ein Signal digitalisiert, das digitalisierte Signal wird einem FIR-Filter zugeführt, und das gefilterte Signal wird einem Digital-Analog-Wandler zugeführt. Auf diese Weise wird durch das Leistungsbegrenzungsmodul ein kausales Komplementärfilter zur Verfügung gestellt, dessen Filterteil digital ausgeführt ist. Auf dem zweiten Signalweg wird der Nutzkanal mittels eines FIR-Filters unterdrückt, während die Nachbarkanäle mit möglichst hohem SNR prozessiert werden. Das gefilterte Signal wird nachfolgend zur weiteren Verarbeitung einem Digital-Analog-Wandler zugeführt.

Vorzugsweise wird in dem FIR-Filter eine Leistungseinstellung, eine Verzögerungseinstellung und eine si(x)-Kompensation durchgeführt. Folglich kann das digitale Signal so aufbereitet werden, dass nachfolgend durch die Kombination mit dem über den ersten Signalweg geleiteten Analogsignal ein Signal entsteht, bei welchem das Nutzband unverändert übertragen wird, während die Nachbarkanäle unterdrückt sind.

Besonders bevorzugt ist es, wenn das FIR-Filter bei der Abtastrate der Wandler betrieben wird. Es kann also ohne Abtastratenreduktion gearbeitet werden.

Vorzugsweise wird in dem ersten Signalweg ein Signal in dem Maße verzögert, welches der Gesamtverzögerung der Wandler und des FIR-Filters des zweiten Signalwegs entspricht. Hierdurch ist sichergestellt, dass die beiden Signalwege zum Zwecke der nachfolgenden Kombination einander angepasst sind.

Besonders bevorzugt ist es, wenn das Signal, welches aus der digitalen Signalverarbeitung resultiert, von dem Signal, welches aus der analogen Signalverarbeitung resultiert, subtrahiert wird. Somit hat das resultierende Signal ein quasi unverändertes Nutzband, während die Nachbarkanäle unterdrückt sind.

Vorzugsweise wird das aus der Subtraktion resultierende Signal einem Analog-Digital-Wandlermodul zugeführt. Die eigentliche Analog-Digital-Wandlung erfolgt daher auf der Grundlage eines Eingangssignals, bei welchem die störenden Nachbarkanäle unterdrückt sind.

Es ist nützlich, wenn das Eingangsfrequenzsignal analog vorverarbeitet wird. Auf diese Weise kann das analoge Eingangssignal durch die analoge Vorverarbeitung soweit gedämpft werden, dass der Wandler auf dem zweiten Signalweg nicht übersteuert wird. Dies ist vorteilhaft, da durch die Wandler auf dem zweiten Signalweg Rauschen entsteht, welches zu dem Originalsignal unkorreliert ist und welches daher auch nicht unterdrückt werden kann. Die Leistungsdichte dieses Rauschbeitrages muss folglich möglichst klein sein (hohes SNR der Nachbarkanäle).

Besonders nützlich ist es, wenn zu dem Eingangsfrequenzsignal ein Kalibrierungssignal zugeführt wird. Dieses Kalibrierungssignal, welches "außerhalb" des Nutzsignals liegt, wird im Digitalteil (Modem) hinter dem Analog-Digital-Wandlermodul ausgewertet. Die Regelung der digitalen Verzögerung kann auf dieser Grundlage erfolgen, und zwar so, dass die Unterdrückung des Kalibrierungssignal maximal ist. Da im Digitalteil die Möglichkeit besteht die Verzögerung adaptiv einzustellen, beispielsweise durch das Zuschalten von Verzögerungsgliedern, besteht für den Analogteil nicht die Notwendigkeit, die Verzögerung absolut einzustellen. Solange diese nur in derselben Größenordnung liegt, ist es möglich, den ersten Signalweg und den zweiten Signalweg aufeinander abzustimmen. Allerdings sollte darauf geachtet werden, dass die Gruppenlaufzeit der analogen Verzögerung über den gesamten interessierenden Frequenzbereich konstant ist.

Bezogen auf eine andere Ausführungsform ist es nützlich, dass ein Ausgangssignal eines Analog-Digital-Wandlers im zweiten Signalweg einem dritten Signalweg zugeführt wird, welcher einen äquivalenten Kanal mit einem komplexen Mischer und einem FIR-Filter realisiert, wobei die Abtastrate reduziert wird. . Hierdurch kann auf eine Bandsperrenfilterung des Nutzbandes auf dem zweiten Signalweg verzichtet werden. Auf diese Weise können die Filteranforderungen an das FIR-Filter drastisch verringert werden. Dementsprechend reicht es aus, wenn das analoge Verzögerungsglied eine nur sehr viel kleinere Verzögerung realisiert, welche etwa um einen Faktor 16 niedriger liegt als bei der Ausführungsform mit Bandsperrenfilterung. Das FIR-Filter auf dem zweiten Signalweg führt daher beispielsweise lediglich eine si(x)-Kompensation, eine Verzögerungseinstellung und eine Leistungseinstellung durch.

Vorteilhafterweise wird das Ausgangssignal des Analog-Digital-Wandlermoduls einem vierten Signalweg zugeführt, welcher einem komplexen Mischer und ein FIR-Filter aufweist, wobei die Abtastrate reduziert wird. Damit wird das Ausgangssignal des Analog-Digital-Wandlermoduls dem Signal des dritten Signalwegs angepasst.

Nützlicherweise wird ein Ausgangssignal des digitalen Signalwegs mit einem Ausgangssignal des vierten Signalweg kombiniert. Durch den Übergang zu einem äquivalenten komplexen Tiefpasssignal und die nachfolgende Kombination der Signale des dritten Signalwegs und des vierten Signalwegs kann somit eine Abtastratenreduzierung, beispielsweise um den Faktor 8 durchgeführt werden.

Es ist bevorzugt, wenn das Ausgangssignal des Analog-Digital-Wandlermoduls über eine Kalibrierungseinheit auf mindestens ein FIR-Filter rückgekoppelt wird. Die Verstärkung lässt sich also in Abhängigkeit der Amplituden-und Phasengänge im Nutzband anpassen.

Ebenfalls ist es bevorzugt, wenn das Ausgangssignal des Analog-Digital-Wandlermoduls über eine Kalibrierungseinheit auf einen einstellbaren Verstärker des Analog-Digital-Wandlermoduls rückgekoppelt wird.

Der Erfindung liegt die überraschende Erkenntnis zugrunde, dass eine Leistungsbegrenzung in Kanälen, welche einem Nutzkanal benachbart sind, durch einen variablen Filter erzielt werden kann. Dieses Filter weist einen fest eingestellten Analogteil, beispielsweise ein Verzögerungsglied, auf und einen variablen Digitalteil, welcher der Frequenz des Nutzkanals angepasst werden kann. Hierdurch ist es nicht mehr erforderlich, kanalspezifische RF-Module zu entwickeln, um die Filter auf die speziellen Frequenzen der Nutzkanäle abzustimmen. Insbesondere bei DMS-Frequenzbändern, welche auf mehrere Betreiber aufgeteilt sind, bietet die Erfindung daher erhebliche Vorteile.

**Zeichnungen**

Die Erfindung wird nun mit Bezug auf die begleitenden Zeichnungen beispielhaft erläutert.

Figur 1 zeigt einen Schaltplan einer ersten Ausführungsform der Erfindung;

Figur 2 zeigt eine spektrale Dichteverteilung im Hinblick auf die Filtercharakteristik einer Bandsperre;

Figur 3 zeigt eine spektrale Dichteverteilung im Hinblick auf die Filtercharakteristik eines kausalen komplementären Bandsperrenfilters;

Figur 4 zeigt eine spektrale Dichteverteilung am Eingang eines Leistungsbegrenzers;

Figur 5 zeigt eine spektrale Dichteverteilung am Eingang eines analogen Addierers;

Figur 6 eine spektrale Dichteverteilung am Eingang eines Analog-Digital-Wandlermoduls;

Figur 7 zeigt eine FIR-Realisierung mittels Filterbank;

Figur 8 zeigt eine spektrale Dichte am Eingang eines Analog-Digital-Wandlermoduls im Szenario minimaler Last;

Figur 9 zeigt eine Einbettung einer erfindungsgemäßen Vorrichtung in ein Gesamtsystem;

Figur 10 zeigt einen Schaltplan einer weiteren Ausführungsform der Erfindung;

Figur 11 zeigt eine Leistungsdichteverteilung am Eingang eines Analog-Digital-Wandlers für das Szenario maximaler Last;

Figur 12 zeigt eine Leistungsdichteverteilung am Eingang eines Analog-Digital-Wandlers für das Szenario minimaler Last;

Figur 13 zeigt eine Leistungsdichteverteilung im Hinblick auf die Berücksichtigung einer Jitterrauschleistung.

**Beschreibung der bevorzugten Ausführungsformen**

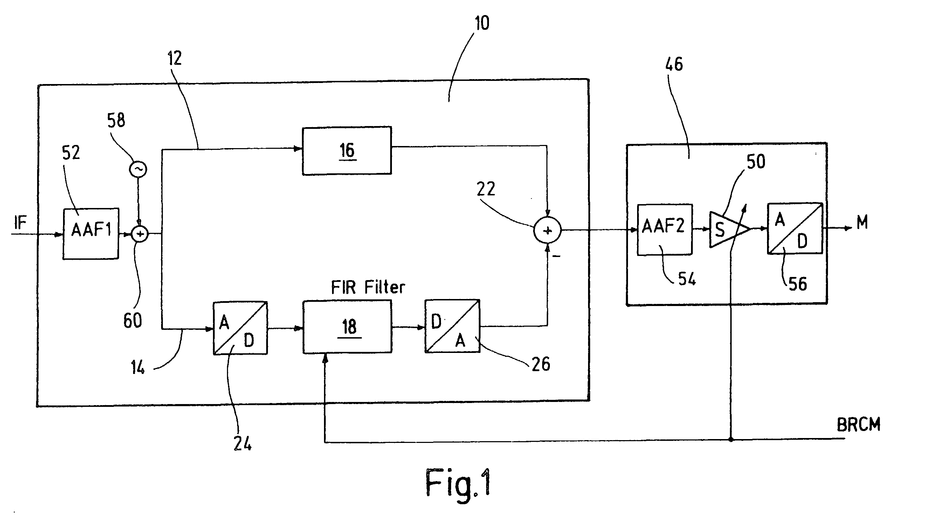

Figur 1 zeigt einen Schaltplan einer erfindungsgemäßen Vorrichtung. Ein Leistungsbegrenzer 10 umfasst einen ersten Signalweg 12 und einen zweiten Signalweg 14. Der erste Signalweg 12 weist ein analoges Verzögerungsglied 16 auf. Der zweite Signalweg 14 umfasst einen Analog-Digital-Wandler 24, ein FIR-Filter 18 und einen Digital-Analog-Wandler 26. In der vorliegenden Zeichnung, wie auch in den anderen Schaltplänen der vorliegenden Patentanmeldung sind beispielhafte Spezifizierungen und mögliche Typen der eingesetzten Bauteile angegeben. Der Leistungsbegrenzer 10 umfasst weiterhin an seinem Ausgang einen analogen Addierer 22. Am Eingang des Leistungsbegrenzers 10 befindet sich ein Element zur analogen Vorverarbeitung 52 sowie ein Mischer 60, welcher neben dem vorverarbeiteten Eingangssignal ein Kalibrierungssignal 58 empfängt. Hinter dem Leistungsbegrenzer 10 befindet sich ein Analog-Digital-Wandlermodul 46. Dieses enthält ein Element zur analogen Vorverarbeitung 54, einen einstellbaren Verstärker 50 und einen Analog-Digital-Wandler 56. Das Ausgangssignal des Analog-Digital-Wandlers wird Modems M zugeleitet. Ebenso sind Signalpfade von einem Broadcastmodem BRCM dargestellt, welche zu dem einstellbaren Verstärker 50 und dem FIR-Filter 18 führen.

Ein Zwischenfrequenzeingangssignal IF wird dem Element zur analogen Vorverarbeitung 52 zugeführt. Dieses wird in einem Mischer 60 mit einem Kalibrierungssignal 58 gemischt. Das Ausgangssignal des Mischers 60 wird auf einen ersten Signalweg 12 und einem zweiten Signalweg 14 aufgeteilt. In dem zweiten Signalweg 14 erfolgt in dem Analog-Digital-Wandler 24 eine Digitalisierung. In dem FIR-Filter 18 erfolgt eine Unterdrückung des erwünschten Nutzkanals, eine Verzögerungseinstellung, eine Leistungseinstellung und eine si(x)-Kompensation. Das Ausgangssignal des FIR-Filters 18 wird einem Digital-Analog-Wandler 26 zugeführt. Das Signal des ersten Signalwegs 12 wird einem analogen Verzögerungsglied 16 zugeführt, dessen Verzögerung auf die Gesamtverzögerung des zweiten Signalwegs 14 abgestimmt ist. Der erste Signalweg 12 und der zweite Signalweg 14 werden schließlich einem analogen Addierer 22 zugeführt, in welchem das Signal des zweiten Signalwegs 14 von dem Signal des ersten Signalwegs 12 subtrahiert wird. Folglich werden die Nebenbänder unterdrückt, während das Nutzband quasi unverändert durch den Leistungsbegrenzer 10 hindurchtritt. Das so gefilterte Signal wird einem Element zur analogen Vorverarbeitung 54 in dem Analog-Digital-Wandlermodul 46 zugeführt, nachfolgend in dem einstellbaren Verstärker 50 verstärkt und schließlich auf einen Analog-Digital-Wandler 56 zur abschließenden Digitalisierung gegeben. Das Ausgangssignal des Analog-Digital-Wandlers wird Modems M zugeführt. Sowohl der einstellbare Verstärker 50 als auch das FIR-Filter 18 sind über ein Broadcastmodem BRCM einstellbar.

Der so realisierte modulare Leistungsbegrenzer 10 ist ein kausales Komplementärfilter, dessen Verzögerungsglied analog und dessen Filterteil digital ausgeführt ist. Im unteren Zweig wird der Nutzkanal mittels eines FIR-Filters 18 unterdrückt. Die Nachbarkanäle werden mit möglichst hohem SNR prozessiert. Am analogen Addierer 22 wird das digital-analog gewandelte Signal von dem verzögerten analogen Originalsignal subtrahiert, wodurch die Nachbarkanäle unterdrückt werden und der Nutzkanal unbeeinflusst bleibt.

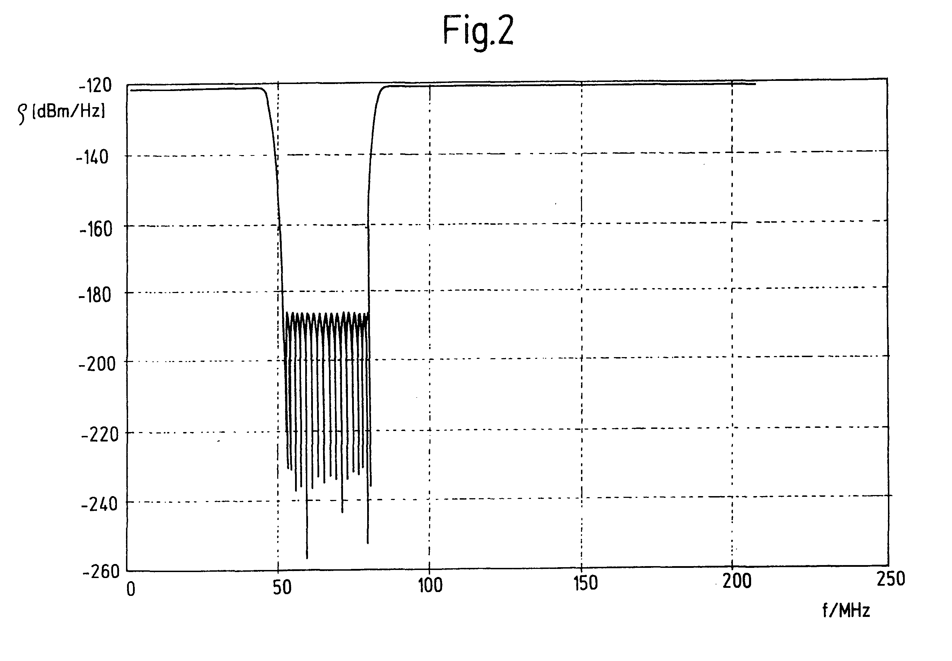

In Figur 2 ist die Übertragungscharakteristik des FIR-Filters 18 zur Unterdrückung des Nutzkanals dargestellt.

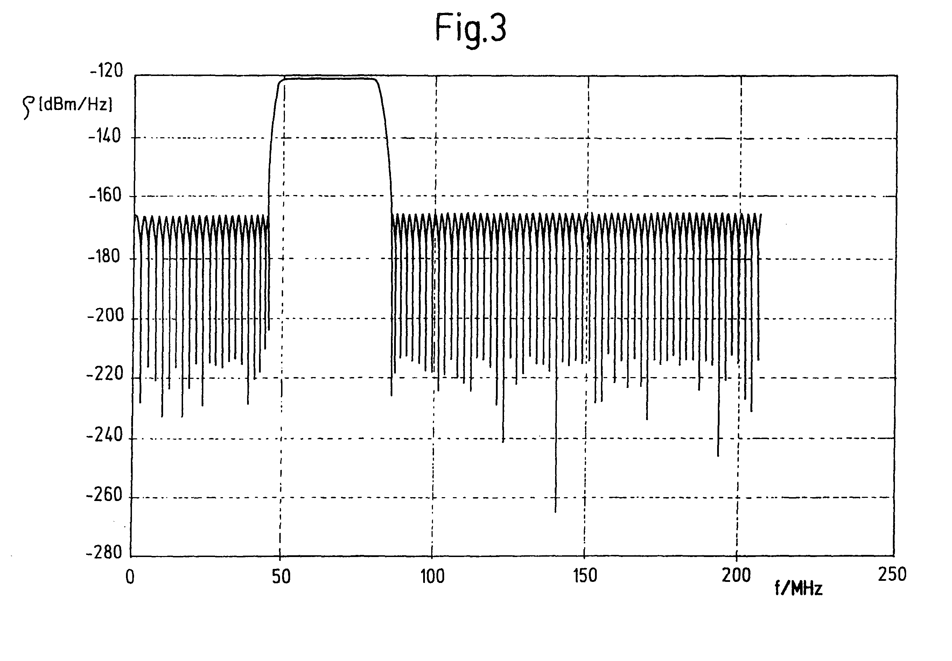

Figur 3 zeigt die Gesamtfiltercharakteristik (Komplementärfilter zu Figur 1) vom Eingang zum Ausgang des modularen Leistungsbegrenzers 10. Das Nutzband wird unverändert übertragen, und die Nachbarkanäle sind unterdrückt.

Bei der Dimensionierung der speziellen Anordnung sind zwei Kriterien wichtig:

- Die Degradation des SNR im Nutzkanal muss möglichst klein sein, das heißt die Rauschleistungsdichte des FIR-Zweigs im Nutzkanal am Eingang des Addierers muss signifikant kleiner sein als die Rauschleistungsdichte des Originalsignals.

- Das SNR in den Nachbarkanälen am Eingang des Addierers soll möglichst groß sein.

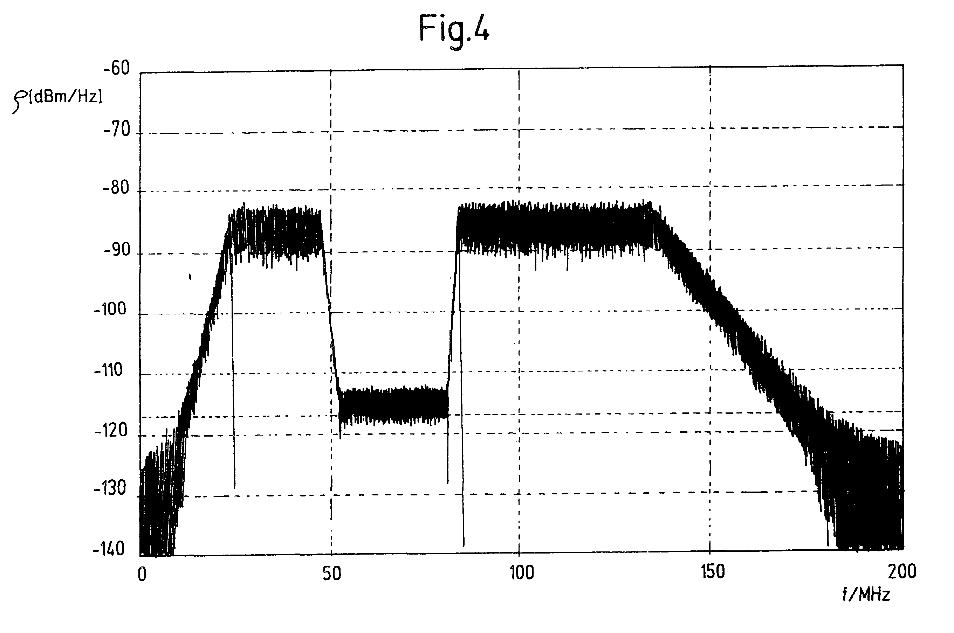

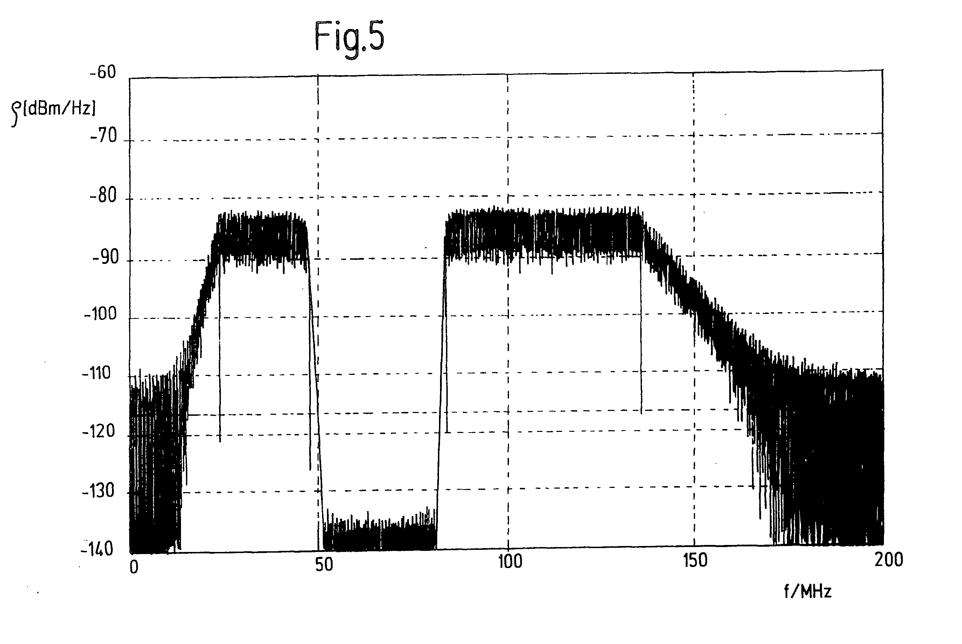

Die Figuren 4, 5 und 6 zeigen die Spektren an verschiedenen Punkten der Anordnung. Es wurde eine Simulation mit folgenden Parametern durchgeführt:

- Vier DMS-Kanäle à 28 MHz, wobei der zweite Kanal als Nutzkanal angenommen wird,

- BNR = 47 dB, das heißt die drei Nachbarkanäle liegen 30 dB über dem Nutzkanal (SNR = 17 dB),

- S = 25 dB, das heißt das analoge Signal muss vor der eigentlichen Analog-Digital-Wandlung um 25 dB verstärkt werden, um das geforderte SNR zu erzielen,

- Analog-Digital-Wandler im FIR-Zweig: F_ADC = 7 nominale Bits bei 414,8 MHz Abtastfrequenz,

- Digital-Analog-Wandler im FIR-Zweig: F_DAC = 11 nominale Bits bei 414,8 MHz Abtastfrequenz,

- Verwendung eines idealen analogen Verzögerungsgliedes.

Figur 4 zeigt das Eingangsspektrum, das mit dem Modell aus Figur 11 vergleichbar ist. Die untere waagrechte Linie deutet die Dichte des Quantisierungsrauschens des Analog-Digital-Wandlers des Converter Moduls an (ADC = 7 Bit). Die analoge Vorverarbeitung skaliert das Signal so, dass der Analog-Digital-Wandlerim FIR-Zweig nicht übersteuert wird. Das SNR im Nutzkanal läge bei dieser Einstellung bei SNR $\cong$ 0 dB.

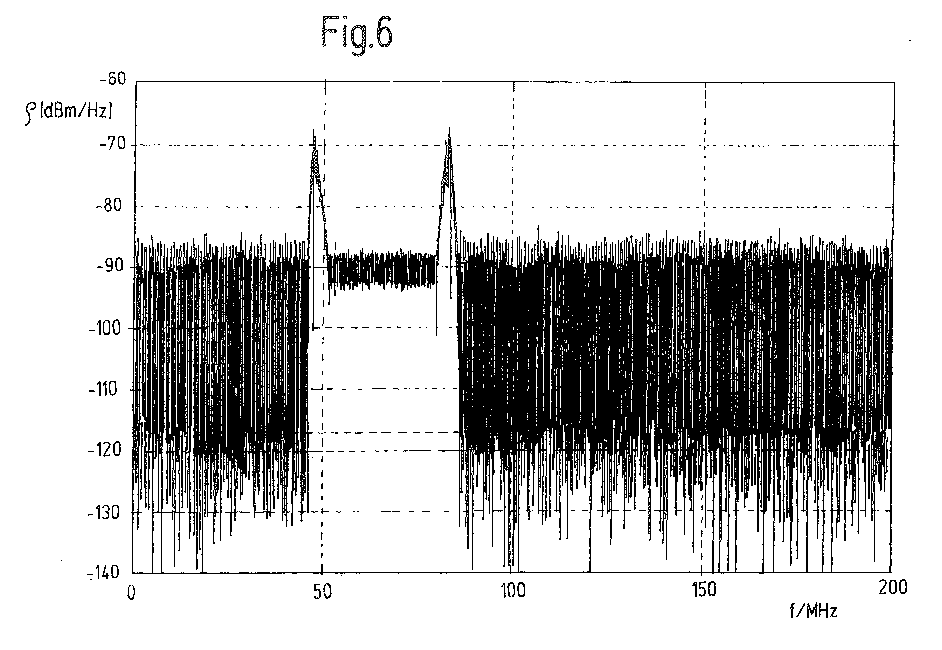

In Figur 6 ist das Spektrum am Eingang des Addierers (FIR-Zweig) dargestellt. Die Rauschleistungsdichte im Nutzkanal ist ca. 20 dB unter der Rauschleistungsdichte des Originalsignales, so dass die Nutzkanal-SNR-Degradation klein ist.

In Figur 6 ist das Spektrum am Eingang des Analog-Digital-Wandlers des Converter Modules nach der Verstärkung gezeigt. Die Nachbarkanäle enthalten nun im Wesentlichen das verstärkte Wandlerrauschen. Die beiden "Zacken" links und rechts vom Nutzkanal enthalten die nicht unterdrückte Nachbarkanal-Signalleistung aufgrund der endlich steilen FIR-Filterflanken.

Die Leistung des Signales nach Figur 6 ist nun so klein, dass der Wandler des Converter-Modules nicht übersteuert wird.

Ein Problem im Hinblick auf die erfindungsgemäße Anordnung besteht darin, die Signalleistung unmittelbar neben dem Nutzkanal effizient zu unterdrücken. Aus diesem Grund sollte das FIR-Filter möglichst steile Filterflanken aufweisen, was zu einem hohen Grad (N > 150) führt. Außerdem ist das Filter bei der Abtastrate der Wandler, also ohne Abtastreduktion, zu prozessieren. Im Hinblick auf das Problem der Abtastraten kann es nützlich sein, das FIR-Filter mittels einer Filterbank zu realisieren.

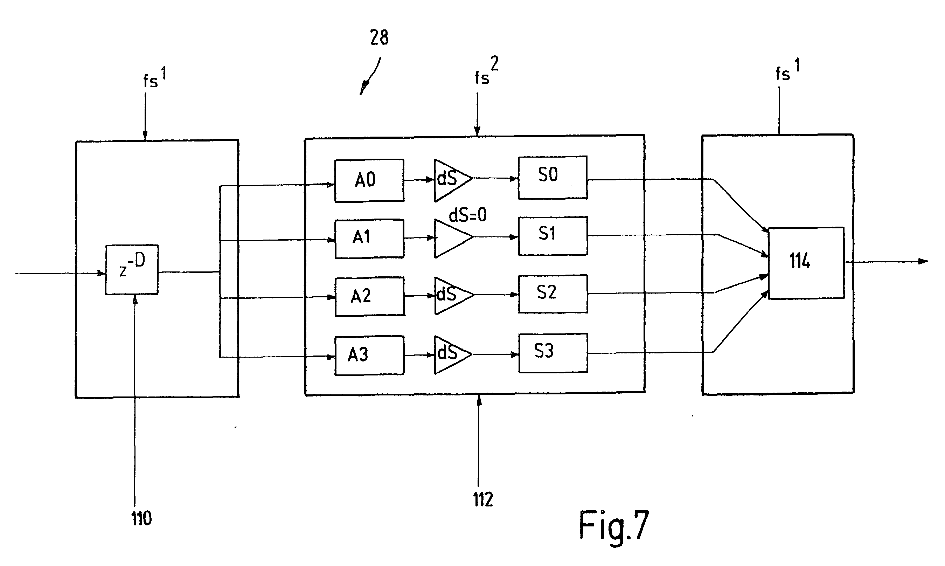

Zur Beschreibung dieser Lösung wird auf Figur 7 Bezug genommen. Diese zeigt eine Anordnung zur groben Verzögerungseinstellung 110 sowie eine Anordnung 112 zur Verstärkungseinstellung, für die Kanalkonfiguration und für die feine Verzögerungseinstellung. Letztere Anordnung 112 umfasst vier Analysefilter A0, A1, A2 und A3, jeweils zugeordnete Verstärker dS und Synthesefilter S0, S1, S2 und S3. Ferner ist ein Addierer 114 vorgesehen, dem die Signale der Synthesefilter S0, S1, S2 und S3 zugeführt werden.

Bei Abtastfrequenzen bis 200 MHz besteht eventuell die Möglichkeit das FIR-Filter direkt zu implementieren, bei Abtastfrequenzen um 400 MHz ist dies zur Zeit wohl nicht möglich. Eine Alternative hierzu bietet die Lösung in Figur 7, die auf einer "Perfect Reconstruction (PR)" Filterbank basiert. Jedes Analysefilter prozessiert ein Bandpass FIR-Filter für einen 28 MHz Kanal, gleichzeitig wird die Abtastrate reduziert, so dass die Filter bei zum Beispiel $\frac{1}{4}$ der Abtastrate gerechnet werden. Das Teilband des Nutzkanals wird ausgeblendet (Zug 1 in Figur 7) wodurch die Bandsperrencharakteristik von Figur 2 erzeugt wird. Die anderen Teilbänder werden mit einem Korrekturwert zum Ausgleich von möglichen Verstärkungs-Fehlanpassungen in den beiden Zügen multipliziert. Durch Verwendung verschiedener Analyse/Synthese-Koeffizientensätze sowie der Verwendung verschiedener Phasen des abwärtsgetasteten Signales kann ein Feinjustierung der Verzögerung vorgenommen werden.

Nach der Synthesefilterung erfolgt die Addition der Teilbandsignale mit der hohen Abtastfrequenz.

Eine Feinjustierung der Verzögerung könnte auch durch Regelung der Digital-Analog-Abtastphase durch den Digitalteil erfolgen.

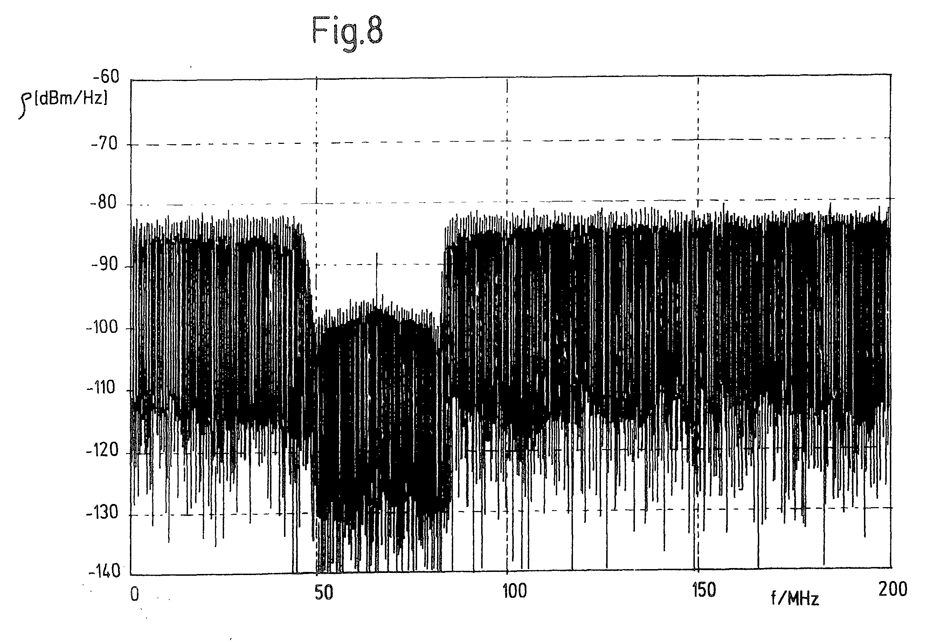

In Figur 8 ist das Spektrum am Eingang des Analog-Digital-Wandlers für das Szenario minimaler Last dargestellt. Wie bereits erwähnt, muss die Signalleistung bei kleiner Kanalbewegung unter Umständen erhöht werden, um eine SNR-Degradation im Nutzkanal zu vermeiden. Das Unterdrückungsmodul kann für dieses Szenario als Dithergenerator eingesetzt werden. Als analoges Eingangssignal wurde entsprechend dem Szenario gemäß Figur 12 ein Signal angenommen, das nur einen Verkehrskanal mit einer Bandbreite von 80 kHz trägt. Es wird deutlich, dass das verstärkte Wandlerrauschen des Unterdrückungsmoduls eine genügende Aussteuerung gewährleistet. Es ist somit keine Steuerung des Wandlerverstärkers als Funktion der belegten Kanäle erforderlich.

Nachfolgend wird die Anordnung gemäß Figur 1 analytisch beschrieben; anhand von Beispielen wird die prinzipielle Durchführbarkeit aufgezeigt. Grundlage für die nachfolgenden Beispiele sind die folgenden Bauelemente:

| Bauelement | Typ | Hersteller | Eigenschaften |
|---|---|---|---|
| AD-Wandler | TS8387 | Thomson | Abtastrate: 500 MHz<br>Anzahl nominaler Bits: 8 |
| DA-Wandler | MB86061 | Fujitsu | Abtastrate: 400 MHz<br>Anzahl nominaler Bits: 12 |
| FPGA | XCV200 | XILINX | 16 x 16 Bit Multiplikationen mit 130 MHz |

In den nächsten beiden Abschnitten werden Nutzkanal und Nachbarkanäle getrennt behandelt und daraus eine Dimensionierung der Systemparameter abgeleitet.

Nutzkanal

Der entscheidende Parameter ist die Degradation $\Delta$ des SNR für den Nutzkanal über die gesamte Verarbeitungskette, das heißt bis zum Ausgang des "Converter Modules". Diese Degradation kann mit Gleichung (12) ermittelt werden.

Die Beziehung berücksichtigt das Rauschen der beiden Analog-Digital-Wandler und des Digital-Analog-Wandlers. Das Rauschen des Wandlerverstärkers blieb ebenso unberücksichtigt wie das Rauschen, das durch endliche Genauigkeit der Signalverarbeitung verursacht wird. Letzteres kann durch entsprechenden Aufwand minimiert werden.

$$\Delta = 10 \cdot \lg(1 + N^S_{FIR} + N^S_{Converter})$$

*mit*

$$N^S_{Converter} = 10^{\frac{S-NQR}{10}} \cdot 2^{2\,ADC} \cdot \left( 2^{-2F\_ADC} \cdot 10^{-\frac{F\_ATT}{10}} + 2^{-2F\_DAC} \right) \quad (12)$$

$$N^S_{FIR} = 10^{\frac{SNR-F\_ATT}{10}} + 10^{-\frac{NQR}{10}}$$

(NQR, ADC und S sind voneinander abhängig)

SNR =       Signal to Noise Ratio" des Nutzkanals in [dB]
NQR =       "Noise to Quantization noise Ratio" in [dB]
S =       Wert des Verstärkers (> 0) in [dB]
ADC =       Anzahl der effektiven Bits des finalen Analog-Digital-Wandlers
F_ADC =       Anzahl der effektiven Bits des Analog-Digital-Wandlers im FIR-Pfad
F_DAC =       Anzahl der effektiven Bits des Digital-Analog-Wandlers im FIR-Pfad
F_ATT =       Dämpfung des Bandsperrenfilters im FIR-Pfad

Der Rauschbeitrag $N^S_{Converter}$ der Wandler wird jetzt noch näher untersucht. Da die Signalleistung durch das Unterdrückungsmodul um S dB reduziert wurde, gilt mit (2) für die Vermeidung der Sättigung:

$$BNR - S = 10 \cdot \lg\left( \frac{3 \cdot 2^{2(ADC-1)} \cdot 10^{\frac{Cr+NQR}{10}} - \frac{W_{CH}}{f_S} \cdot 10^{\frac{SNR}{10}} + \frac{2 \cdot W_F + W}{f_S} - \frac{1}{2}}{\frac{W_F + W - W_{CH}}{f_S}} \right) \quad (13)$$

Eingesetzt erhält man:

$$N_{Converter}^{S}=10^{\frac{BNR-NQR}{10}}\cdot\frac{\frac{W_F+W-W_{CH}}{f_S}\cdot\left(2^{-2F\_ADC}\cdot10^{\frac{F\_ATT}{10}}+2^{-2F\_DAC}\right)}{0,75\cdot10^{\frac{Cr+NQR}{10}}-2^{-2ADC}\left(\frac{W_{CH}}{f_S}\cdot10^{\frac{SNR}{10}}-\frac{2\cdot W_F+W}{f_S}+\frac{1}{2}\right)}$$

Die Auflösung des Analog-Digital-Wandlers F_ADC ist unkritisch, da das Quantisierungsrauschen mit der Dämpfung des FIR-Filters gewichtet wird. Entscheidend ist die Auflösung des Digital-Analog-Wandlers. Mit:

BNR = 47 dB
SNR = 17 dB
ADC = 7 Bit
F_ADC = 7 Bit
F_DAC = 11 Bit
F_ATT = 60 dB
NQR = 13 dB
Cr = 10 dB
W = 112 MHz
W_CH = 28 MHz
W_F = 28 MHz
f_s = 414,8 MHz

erhält man

$$N_{Converter}^{S}=0,046$$

als Rauschbeitrag der Wandler.

Beim Rauschbeitrag des FIR-Filters ist der erste Term unkritisch. Mit SNR = 17 dB und F_ATT = 60 dB erhält man einen zu $N_{Converter}^{S}$ vernachlässigbar kleinen Beitrag. Bestimmend ist hier die Größe NQR.

Insgesamt erhält man:

$$N_{FIR}^{S}=0,00005+0,05\approx0,05$$

als Rauschbeitrag des FIR-Filters.

Die Degradation des Nutzkanals vom Eingang des Unterdrückungsmoduls bis zum Ausgang des Converter Modules beträgt für dieses Zahlenbeispiel:

$$\Delta=10\cdot\lg(1+0,046+0,05)=0,4dB.$$

Nachbarkanäle

Entscheidendes Kriterium ist die Unterdrückung der Nach-barkanalfrequenzen. Diese kann mit Gleichung (14) als Funktion der Frequenz berechnet werden.

Diese Beziehung berücksichtigt das Rauschen der Wandler, die Eigenschaft des FIR-Filters sowie Ungenauigkeiten im Analogteil (unterschiedliche Signallaufzeiten im Digital-und Analogzweig). Das Rauschen, das durch endliche Genauigkeit der Signalverarbeitung verursacht wird, sowie das Verstärkerrauschen wurden nicht berücksichtigt (siehe oben).

Anzustreben ist eine Unterdrückung der Nachbarkanäle von mindestens 20 dB (Beispiel 2). Für diesen Wert werden die Anforderungen berechnet.

$$Sup(f)=-10\cdot lg\left(10^{-\frac{CF\_ATT}{10}}+N^{P}_{Converter}+N_{Analog}(f)\right)$$

mit

$$N^{P}_{Converter}=10^{-\frac{BNR-S}{10}}\cdot 10^{\frac{NQR}{10}}\cdot 2^{2ADC}\cdot(2^{-2F\_ADC}+2^{-2F\_DAC}) \tag{14}$$

$$N_{Analog}(f)=2\cdot(1-cos(2\pi f|\tau|))$$

mit

BNR =     "Blocking to Noise Ratio" der Nachbarkanäle in [dB]
NQR =     "Noise to Quantization noise Ratio" in [dB]
S =     Wert des Verstärkers (> 0) in [dB]
ADC =     Anzahl der effektiven Bits des finalen Analog-Digital-Wandlers
F_ADC =     Anzahl der effektiven Bits des Analog-Digital-Wandlers im FIR-Pfad
F_DAC =     Anzahl der effektiven Bits des Digital-Analog-Wandlers im FIR-Pfad
CF_ATT =     Dämpfung des komplementären Bandsperrenfilters (⇔ Ripple der Bandsperre)
$\tau$ =     Signallaufzeitdifferenz am Addierer zwischen den beiden Pfaden in [sec]

Unter Verwendung von (13) ergibt sich für den Beitrag $N^{P}_{Converter}$ :

$$N^{P}_{Converter}=10^{-\frac{NQR}{10}}\cdot\frac{\frac{W_{F}+W-W_{CH}}{f_{s}}\cdot\left(2^{-2F\_ADC}+2^{-2F\_DAC}\right)}{0,75\cdot 10^{-\frac{Cr+NQR}{10}}-2^{-2ADC}\left(\frac{W_{CH}}{f_{s}}\cdot 10^{\frac{SNR}{10}}-\frac{2\cdot W_{F}+W}{f_{s}}+\frac{1}{2}\right)}$$

Das Rauschen der AD-DA-Wandlerkette vermindert das erzielbare SNR in den Nachbarkanälen und damit deren Unterdrückung am Ausgang des Addierers.
Mit den realistischen Werten:

ADC =     7 Bit
F_ADC =     7 Bit
F_DAC =     11 Bit
SNR =     17 dB
NQR =     13 dB
Cr =     10 dB
W =     112 MHz
W_CH =     28 MHz
W_F =     28 MHz
f_s =     414,8 MHz

erhält man

$$N^{P}_{Converter}=0,00023.$$

Während für den Nutzkanal die Auflösung des Analog-Digital-Wandlers im FIR-Zweig nahezu bedeutungslos war, geht hier die Auflösung direkt ein. Auf der anderen Seite könnte die Auflösung des Digital-Analog-Wandlers hier vermindert werden.

Dies ist ein sehr kritischer Beitrag. Dieser Term ist frequenzabhängig und die Anforderungen an die Verzögerungsgenauigkeit steigt mit der Signalfrequenz. Um am Bandende ($f_{max}$ = 136 MHz) noch die geforderte Dämpfung von 20 dB zu erzielen muss die Bedingung (Gleichung 14)

$$|\tau| < 0,12 \text{ns}$$

erfüllt sein.

Am Bandanfang (zum Beispiel f = 24 MHz) ist die Bedingung weniger scharf:

$$|\tau| < 0,68 \text{ns}$$

Mit diesen Werten und CF_ATT = 45 dB (Figur 3) ergibt sich als minimal erzielbare Dämpfung der Nebenkanäle:

$$\text{Sup (f)} > -10 \cdot \lg(0,00003+0,00023+0,01) \approx 20\text{dB für f} \in [24,136 \text{ MHz}]$$

Es wird deutlich, dass die Fehlanpassung die Höhe der Unterdrückung der Nebenkanäle entscheidend bestimmt.

Die Anforderungen an den Taktjitter werden nun von den Nachbarkanälen bestimmt. Da am Eingang des Addierers ein Signal zu Rauschverhältnis von Sup(f) = 20 dB anliegt, genügt es die Forderung

$$\text{SJR - Sup(f)} > 10 \text{ dB}$$

zu erfüllen. Die Bedingung für das Converter Modul ist wie in Beispiel 2 Gleichung (9):

$$\text{SJR - SNR} > \text{NQR} + 10 \text{ dB}$$

Diese letzte Bedingung ist sicherlich die schärfere, so dass die Anforderung an den Taktjitter für die Gesamtanordnung

$$\sigma \leq 18,5 \text{ psec}$$

beträgt.

Insgesamt sind folgende Anforderungen an den Analogteil zu stellen:

- Das analoge Verzögerungsglied muss über den interessierenden Frequenzbereich eine konstante Gruppenlaufzeit in der Größenordnung von 250 ns realisieren. Die erlaubten Abweichungen reichen von maximal +/- 0,68 ns bei tiefen Frequenzen bis maximal +/- 0,12 ns bei hohen Frequenzen.

- Der analoge Addierer muss über den interessierenden Frequenzbereich verzerrungsfrei arbeiten. Es ist zu beachten, dass das digital-analog-gewandelte Signal eine sehr viel höhere Bandbreite besitzt als das Originalsignal.

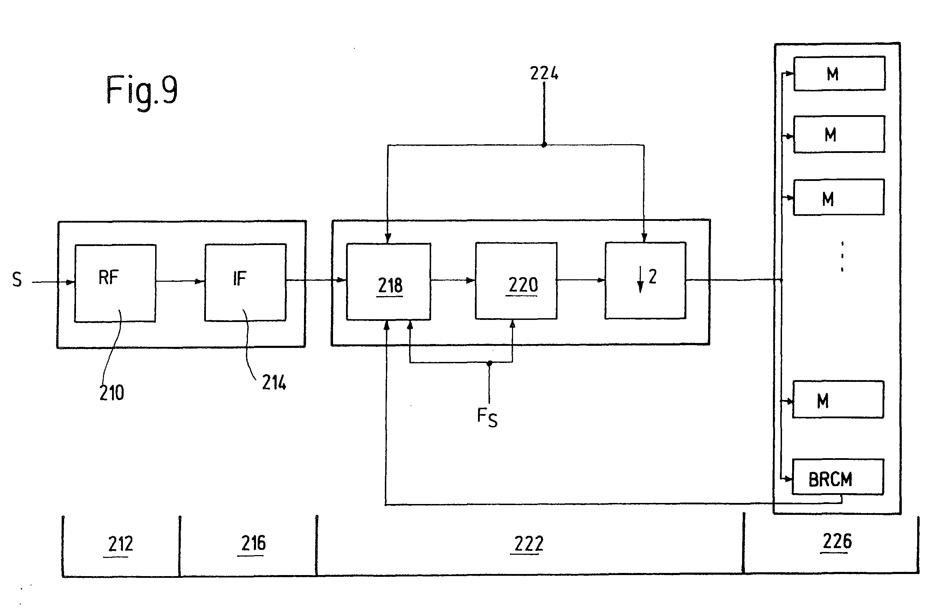

Figur 9 zeigt eine mögliche Einbettung der Erfindung in ein Gesamtsystem. Am unteren Rand der Darstellung sind die funktionellen Gruppen durch Bezugszeichen gekennzeichnet. Dabei bezeichnet 212 vier unterschiedliche RF-Module, 216 zwei unterschiedliche IF-Module, 222 einen Converter vom analog/digitalen Typ und 226 ein Modem vom digitalen Typ.

Ein Signal S wird einem RF-Modul 210 zugeführt. Dessen Ausgangssignal wird einem IF-Modul 114 eingegeben. Der Ausgang des IF-Moduls wird einem Element zur Unterdrückung außerhalb des Kanals 218 eingegeben. Dessen Ausgangssignal führt zu einem Converter Modul 220. Das resultierende 207,4 MHz-Signal wird an die Modems M verteilt. Das zentrale Broadcastmodem BRCM verarbeitet das Kalibrierungssignal und generiert entsprechende Justierinformationen für den Digitalteil des Unterdrückungsmoduls.

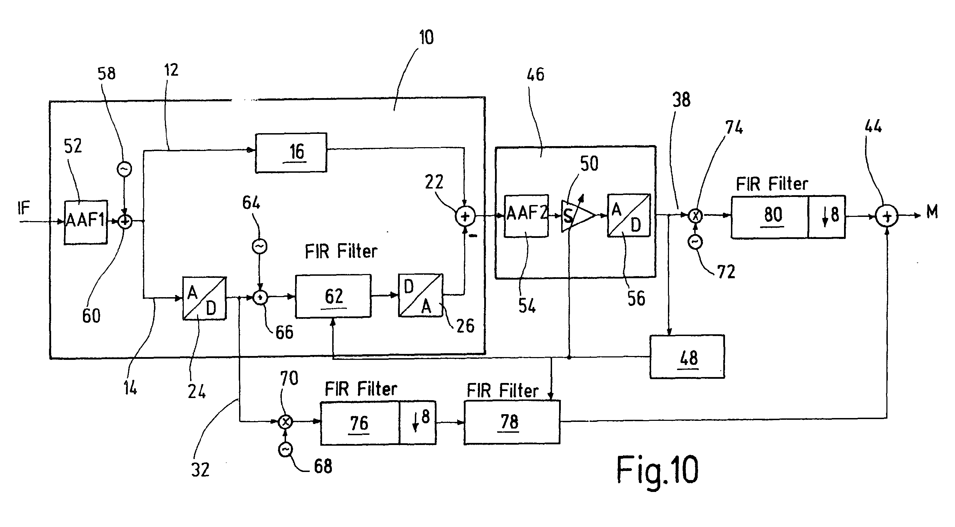

In Figur 10 ist eine andere Ausführungsform der Erfindung dargestellt. Elemente, welche den in Figur 1 dargestellten Elementen entsprechen, sind mit denselben Bezugszeichen gekennzeichnet. Im Unterschied zu der Ausführungsform gemäß Figur 1 ist in dem Leistungsbegrenzer 10 ein FIR-Filter 62 vorgesehen, welches keine Bandsperrenfilterung des Nutzbandes vornimmt. Zusätzlich ist ein dritter Signalweg 32 vorgesehen, welcher hinter dem Analog-Digital-Wandler 24 des zweiten Signalwegs 14 abzweigt. Dieser umfasst einen Mischer 70, in welchem das abgezweigte Signal mit einem weiteren Signal 78 gemischt wird. Das Ausgangssignal des Mischers wird einem FIR-Filter 76 zugeführt. Es wird eine Abtastratenreduzierung vorgenommen. Das resultierende Ausgangssignal wird einem weiteren FIR-Filter 78 zugeführt. Hinter dem Analog-Digital-Wandlermodul 46 setzt ein vierter Signalweg 38 an. Auch hier wird das Signal in einem Mischer 74 mit einem weiteren Signal 72 gemischt. Das Ausgangssignal des Mischers wird einem FIR-Filter 80 zugeführt, wobei auch hier eine Abtastratenreduzierung vorgenommen wird. Das Ausgangssignal des vierten Signalwegs 38 und das Ausgangssignal des zweiten Signalwegs 32 werden einem Addierer 44 zugeführt. Dessen Ausgangssignal wird auf die Modems M geleitet.

Da in dem FIR-Filter 62 auf eine Bandsperrenfilterung des Nutzbandes verzichtet wird, können die Filteranforderungen an das FIR-Filter 62 drastisch verringert werden. Das analoge Verzögerungsglied 16 muss daher eine viel kleinere Verzögerung realisieren, welche beispielsweise um einen Faktor 16 niedriger ist. Allerdings steigen hierdurch die Anforderungen an die digitale Nachverarbeitung. Ebenso ist zu berücksichtigen, dass hierdurch eine genaue Kenntnis der Verhältnisse (Amplituden- und Phasengang im Nutzband) zwischen dem Digital-Analog-Wandler und dem nachfolgenden Analog-Digital-Wandler notwendig wird.

Nach dem ersten Analog-Digital-Wandler wird für die vier 28 MHz-Bänder wie beim vorherigen System eine si(x)-Kompensation sowie ein Delay- und Power-Adjustment durchgeführt. Eine Bandsperrenfilterung des Nutzbandes ist nicht notwendig. Hinter dem Digital-Analog-Wandler sind deshalb starke Signalanteile im Nutzband möglich, die weit über dem Quantisierungsrauschen des Digital-Analog-Wandlers liegen. Diese Störanteile müssen deshalb hinter dem zweiten Analog-Digital-Wandler kompensiert werden. Hierzu wird digital ein äquivalenter Kanal realisiert. Da nur das Nutzband interessiert, kann durch Übergang zum äquivalenten komplexen Tiefpasssignal eine Abtastratenreduzierung um den Faktor 8 durchgeführt werden.

Bei der vorliegenden Ausführungsform sind die folgenden Probleme besonders zu berücksichtigen:

- Es ist ein analoges Verzögerungsglied notwendig, das über den interessierenden Frequenzbereich von zum Beispiel 20 bis 150 MHz eine konstante Gruppenlaufzeit in der Größenordnung von 15 ns aufweist. Stimmen die Verzögerungen in beiden Zweigen nicht überein, vermindert sich die Filterwirkung. Die Filterwirkung vermindert sich auch, wenn die Verstärkung in den Zweigen unterschiedlich ist.

- Ein si(x)-Kompensationsfilter ist bei Wandlerabtastrate (414,8 MHz) zu prozessieren.

- Die Signalanteile, die über den Digital-Analog-Wandler gehen und im Addierer das Nutzsignal verfälschen, müssen durch eine digitale Nachverarbeitung kompensiert werden. Hierzu ist eine sehr genaue Kenntnis des Amplitudenganges sowie der Verzögerung notwendig. Die digitale Realisierung muss entsprechend fein abgestimmt erfolgen.

Die analytische Beschreibung und Dimensionierung der hier dargestellten Ausführungsform ist wie folgt:
Der entscheidende Parameter ist die Degradation Δ des SNR für den Nutzkanal über die gesamte Verarbeitungskette, das heißt bis zum Ausgang des "Converter Modules". Diese Degradation kann mit Gleichung (15) ermittelt werden.
Für eine einfache Berechnung und Darstellung wird angenommen, dass das System aus si(x)-Kompensation, Digital-Analog-Wandler, Addierer, AAF2, Verstärker und Analog-Digital-Wandler einen idealen Frequenzgang mit der Verstärkung S im Nutzband realisiert und sämtliche Abweichungen durch Anpassungsfehler im äquivalenten Kanal beschrieben werden.
In den Rechnungen wird das Rauschen der beiden Analog-Digital-Wandler und des Digital-Analog-Wandlers berücksichtigt, nicht aber das Rauschen des Wandlerverstärkers.

$$\Delta = 10 \cdot \lg\left(1 + N_{Model}^{S} + N_{DA}^{S} + 10^{\frac{NQR}{10}}\right)$$

mit

$$N_{DA}^S = 10^{\frac{S\text{-}NQR}{10}} \cdot 2^{2(ADC-F\_DAC)}$$

$$N_{Model}^S = \left(10^{\frac{S-NQR}{10}} \cdot 2^{2(ADC-F\_ADC)} - 10^{\frac{SNR}{10}}\right) \cdot \left(1 - 2 \cdot 10^{\frac{\delta}{20}} \cdot \cos(2\pi f\varepsilon) + 10^{\frac{\delta}{10}}\right)$$

$$(15)$$

mit

| | |
|---|---|
| SNR = | Signal to Noise Ratio" des Nutzkanals in [dB] |
| NQR = | "Noise to Quantization noise Ratio" in [dB] |
| S = | Wert des Verstärkers (> 0) in [dB] |
| ADC = | Anzahl der effektiven Bits des finalen Analog-Digital-Wandlers |
| F_ADC = | Anzahl der effektiven Bits des Analog-Digital-Wandlers im FIR-Pfad |
| F_DAC = | Anzahl der effektiven Bits des Digital-Analog-Wandlers im FIR-Pfad |
| F_ATT = | Dämpfung des Bandsperrenfilters im FIR-Pfad |
| $\delta$ = | Fehlanpassung des Amplitudenganges im äquivalenten Kanal in dB |
| $\varepsilon$ = | Signallaufzeitfehler des äquivalenten Kanals |

Der Rauschbeitrag $N_{DA}^S$ des Digital-Analog-Wandlers wird jetzt noch näher untersucht. Da die Signalleistung durch das Unterdrückungsmodul um S dB reduziert wurde, gilt mit (13):

$$N_{DA}^S = 10^{\frac{BNR-NQR}{10}} \cdot \frac{\frac{W_F + W - W_{CH}}{f_S} \cdot \left(2^{-2F\_DAC}\right)}{0{,}75 \cdot 10^{\frac{Cr+NQR}{10}} - 2^{-2ADC}\left(\frac{W_{CH}}{f_S} \cdot 10^{\frac{SNR}{10}} - \frac{2 \cdot W_F + W}{f_S} + \frac{1}{2}\right)}$$

Entscheidend ist hier die Auflösung des Digital-Analog-Wandlers.
Mit:

| | |
|---|---|
| BNR = | 47 dB |
| SNR = | 17 dB |
| ADC = | 7 Bit |
| F_ADC = | 7 Bit |
| F_DAC = | 11 Bit |
| NQR = | 13 dB |
| Cr = | 10 dB |
| W = | 1.12 MHz |
| W_CH = | 28 MHz |
| W_F = | 28 MHz |
| f_s = | 414,8 MHz |

erhält man

$$N_{DA}^{S} = 0,043$$

Die Auflösung des Analog-Digital-Wandler F_ADC ist unkritisch, wenn die hierdurch verursachte Rauschleistungsdichte kleiner als die Nutzsignalleistungsdichte ist.

Mit $\delta$ = 0,05 dB und $\varepsilon$ = 20 ps erhält für f = 1136 MHz sowie den obigen Werten

$$N_{Model}^{S} = 0,020$$

Mit $10^{-\frac{NQR}{10}}$=0,05 beträgt die Degradation für dieses Zahlenbeispiel

$$\Delta = 10 \cdot \lg(1 + 0,020 + 0,043 + 0,05) = 0,47 dB$$

Für $\varepsilon$=10ps verringert sich die Degradation auf $\Delta$=0,42dB.

Für die Unterdrückungsfähigkeit ist die Leistung im Nutzband unwesentlich, da die Nachbarkanäle die wesentlich höhere Leistung haben können. Ist dieses nicht zutreffend, so besteht sowieso kein Unterdrückungsproblem.

Für die Unterdrückungsfähigkeit der Nachbarkanäle gilt deshalb auch die Gleichung (14).

Für die Anforderungen an den Taktjitter ist wieder der Taktjitter am Digital-Analog-Wandler entscheidend.

Für die Berechnung des zulässigen Taktjitters muss beachtet werden, dass das Quantisierungsrauschen des ersten Analog-Digital-Wandlers durchaus in der Größenordnung des Signalpegels im Nutzband sein kann und daher mit in die Berechnung einfließen muss (1. Summand unterhalb der Wurzel).

$$\sigma_j \leq \frac{10^{-\frac{SJR-SNR}{20}}}{2\cdot\pi\cdot f\cdot\sqrt{10^{-\frac{S-NQR}{10}}\cdot 2^{2(ADC-F\_ADC)}+10^{\frac{SNR}{10}}}}$$

SNR =     "Signal to Noise Ratio" in [dB]
SJR =     "Signal to Jitter Ratio" in [dB]
NQR =     "Noise to Quantization noise Ratio" in [dB]
S =     Wert des Verstärkers (> 0) in [dB]
ADC =     Anzahl der effektiven Bits des finalen Analog-Digital-Wandlers
F_ADC =     Anzahl der effektiven Bits des Analog-Digital-Wandlers im FIR-Pfad

Mit den bekannten Zahlen und der Bedingung

$$SJR - SNR > NQR + 10\ dB$$

ergibt sich die Anforderung an den Taktjitter zu:

$$\sigma_j \leq 10\ psec.$$

Insgesamt sind folgende Anforderungen an den Analogteil zu stellen:

- Das analoge Verzögerungsglied muss über den interessierenden Frequenzbereich eine konstante Gruppenlaufzeit in der Größenordnung von 15 ns realisieren. Die erlaubten Abweichungen reichen von maximal +/- 0,68 ns bei tiefen Frequenzen bis maximal +/- 0,12 ns bei hohen Frequenzen.

- Der analoge Addierer muss über den interessierenden Frequenzbereich verzerrungsfrei arbeiten. Es ist zu beachten, dass das digital-analog-gewandelte Signal eine sehr viel höhere Bandbreite besitzt als das Originalsignal.

Nach der digitalen Nachverarbeitung liegt ein 28 MHz-Kanal als komplexes Basisbandsignal vor. Es können weitere drei 28 MHz - Bänder ohne zusätzliche Wandler verarbeitet werden. Die digitale Nachverarbeitung muss hierzu nur mehrfach aufgebaut werden.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

**Patentansprüche**

1. Vorrichtung zum Verarbeiten von Frequenzsignalen mit einem Leistungsbegrenzer (10), **dadurch gekennzeichnet,**

   - **dass** der Leistungsbegrenzer (10) einen ersten Signalweg (12) aufweist,
   - **dass** der Leistungsbegrenzer (10) einen zweiten Signalweg (14) aufweist,
   - **dass** der erste Signalweg (12) Mittel (16) zur analogen Signalverarbeitung aufweist,
   - **dass** der zweite Signalweg (14) Mittel (18) zur digitalen Signalverarbeitung aufweist,
   - **dass** die Mittel (18) zur digitalen Signalverarbeitung Mittel zum selektiven Unterdrücken bestimmter Frequenzbereiche aufweisen und
   - **dass** ein Ausgang des ersten Signalwegs (12) und ein Ausgang des zweiten Signalwegs (14) mit Mitteln (22) zum Kombinieren von Signalen verbunden sind.

2. Vorrichtung nach Anspruch 1, **dadurch gekennzeichnet, dass** der zweite Signalweg (14) einen Analog-Digital-Wandler (24), ein FIR-Filter (18) und einen Digital-Analog-Wandler (26) aufweist.

3. Vorrichtung nach Anspruch 1 oder 2, **dadurch gekennzeichnet, dass** in dem FIR-Filter (18) eine Leistungseinstellung, eine Verzögerungseinstellung und eine si(x)-Kompensation durchführbar sind.

4. Vorrichtung nach einem der vorangehenden Ansprüche, **dadurch gekennzeichnet, dass** das FIR-Filter (18) steile Filterflanken aufweist.

5. Vorrichtung nach einem der vorangehenden Ansprüche, **dadurch gekennzeichnet, dass** das FIR-Filter (18) bei der Abtastrate der Wandler (24, 26) arbeitet.

6. Vorrichtung nach einem der vorangehenden Ansprüche, **dadurch gekennzeichnet, dass** das FIR-Filter (18) mittels einer Filterbank (28) realisiert ist.

7. Vorrichtung nach einem der vorangehenden Ansprüche, **dadurch gekennzeichnet, dass** der erste Signalweg (12) ein analoges Verzögerungsglied (16) aufweist.

8. Vorrichtung nach einem der vorangehenden Ansprüche, **dadurch gekennzeichnet, dass** das analoge Verzögerungsglied (16) eine konstante Gruppenlaufzeit aufweist.

9. Vorrichtung nach einem der vorangehenden Ansprüche, **dadurch gekennzeichnet, dass** die konstante Gruppenlaufzeit der Gesamtverzögerung der Wandler (24, 26) und des FIR-Filters (18) entspricht.

10. Vorrichtung nach einem der vorangehenden Ansprüche, **dadurch gekennzeichnet, dass** die Mittel zum Kombinieren von Signalen einen analogen Addierer (22) aufweisen.

11. Vorrichtung nach einem der vorangehenden Ansprüche, **dadurch gekennzeichnet, dass** das Ausgangssignal des analogen Addierers (22) einem Analog-Digital-Wandlermodul (46) zuführbar ist.

12. Vorrichtung nach einem der vorangehenden Ansprüche, **dadurch gekennzeichnet, dass** das Eingangsfrequenzsignal Mitteln (52) zur analogen Vorverarbeitung zuführbar ist.

13. Vorrichtung nach einem der vorangehenden Ansprüche, **dadurch gekennzeichnet, dass** zu dem Eingangsfrequenzsignal ein Kalibrierungssignal (58) einspeisbar ist.

14. Vorrichtung nach einem der vorangehenden Ansprüche, **dadurch gekennzeichnet, dass** ein dritter Signalweg (32) vorgesehen ist, welcher digital einen äquivalenten Kanal realisiert, in welchem eine Abtastratenreduzierung erfolgt, wobei der dritte Signalweg (32) einen komplexen Mischer (34) und ein FIR-Filter (76, 78) aufweist.

**15.** Vorrichtung nach einem der vorangehenden Ansprüche, **dadurch gekennzeichnet, dass** das Ausgangssignal des Analog-Digital-Wandlermoduls (46) einem vierten Signalweg (38) zuführbar ist, in welchem eine Abtastratenreduzierung erfolgt, wobei der vierte Signalweg (38) einen komplexen Mischer (70) und ein FIR-Filter (72) aufweist.

**16.** Vorrichtung nach einem der vorangehenden Ansprüche, **dadurch gekennzeichnet, dass** ein Ausgang des dritten Signalwegs (32) und ein Ausgang des vierten Signalwegs (38) mit Mitteln (44) zum Kombinieren von Signalen verbunden sind.

**17.** Vorrichtung nach einem der vorangehenden Ansprüche, **dadurch gekennzeichnet, dass** das Ausgangssignal des Analog-Digital-Wandlermoduls (46) über eine Kalibrierungseinheit (48) auf mindestens ein FIR-Filter (62, 78) rückkoppelbar ist.

**18.** Vorrichtung nach einem der vorangehenden Ansprüche, **dadurch gekennzeichnet, dass** das Ausgangssignal des Analog-Digital-Wandlermoduls (46) über eine Kalibrierungseinheit (48) auf einen einstellbaren Verstärker (50) des Analog-Digital-Wandlermoduls (46) rückkoppelbar ist.

**19.** Verfahren zum Verarbeiten von Frequenzsignalen, bei dem eine Leistung begrenzt wird, **dadurch gekennzeichnet,**

- **dass** das Frequenzsignal einem ersten Signalweg (12) zugeführt wird,
- **dass** das Frequenzsignal einem zweiten Signalweg (14) zugeführt wird,
- **dass** in dem ersten Signalweg (12) eine analoge Signalverarbeitung stattfindet,
- **dass** in dem zweiten Signalweg (14) eine digitale Signalverarbeitung stattfindet,
- **dass** bei der digitalen Signalverarbeitung bestimmte Frequenzbereiche selektiv unterdrückt werden und
- **dass** ein Signal, welches aus der analogen Signalverarbeitung resultiert, mit einem Signal, welches aus der analogen Signalverarbeitung resultiert, kombiniert wird.

**20.** Verfahren nach Anspruch 19, **dadurch gekennzeichnet, dass** in dem zweiten Signalweg (14) ein Signal digitalisiert wird, das digitalisierte Signal einem FIR-Filter (18) zugeführt wird und das gefilterte Signal einem Digital-Analog-Wandler (26) zugeführt wird.

**21.** Verfahren nach Anspruch 19 oder 20, **dadurch gekennzeichnet, dass** in dem FIR-Filter eine Leistungseinstellung, eine Verzögerungseinstellung und eine si(x)-Kompensation durchgeführt wird.

**22.** Verfahren nach einem der Ansprüche 19 bis 21, **dadurch gekennzeichnet, dass** das FIR-Filter (18) bei der Abtastrate der Wandler (24, 26) betrieben wird.

**23.** Verfahren nach einem der Ansprüche 19 bis 22, **dadurch gekennzeichnet, dass** in dem ersten Signalweg (32) ein Signal in einem Maße verzögert wird, welches der Gesamtverzögerung der Wandler (24, 26) und des FIR-Filters (18, 62) des zweiten Signalwegs (14) entspricht.

**24.** Verfahren nach einem der Ansprüche 19 bis 23, **dadurch gekennzeichnet, dass** das Signal, welches aus der digitalen Signalverarbeitung resultiert, von dem Signal, welches aus der analogen Signalverarbeitung resultiert, subtrahiert wird.

**25.** Verfahren nach einem der Ansprüche 19 bis 24, **dadurch gekennzeichnet, dass** das aus der Subtraktion resultierende Signal einem Analog-Digital-Wandlermodul (46) zugeführt wird.

**26.** Verfahren nach einem der Ansprüche 18 bis 25, **dadurch gekennzeichnet, dass** das Eingangsfrequenzsignal analog vorverarbeitet wird.

**27.** Verfahren nach einem der Ansprüche 19 bis 26, **dadurch gekennzeichnet, dass** zu dem Eingangsfrequenzsignal ein Kalibrierungssignal (58) zugeführt wird.

**28.** Verfahren nach einem der Ansprüche 19 bis 27, **dadurch gekennzeichnet, dass** ein Ausgangssignal eines Analog-Digital-Wandlers (24) in dem zweiten Signalweg (14) einem dritten Signalweg (32) zugeführt wird, welcher einen äquivalenten Kanal mit einem komplexen Mischer (68) und einem FIR-Filter (76, 78) realisiert, wobei die Abtastrate reduziert wird.

29. Verfahren nach einem der Ansprüche 19 bis 28, **dadurch gekennzeichnet, dass** das Ausgangssignal des Analog-Digital-Wandlermoduls (46) einem vierten Signalweg (38) zugeführt wird, welcher einen komplexen Mischer (74) und ein FIR-Filter (80) aufweist, wobei die Abtastrate reduziert wird.

30. Verfahren nach einem der Ansprüche 19 bis 29, **dadurch gekennzeichnet, dass** ein Ausgangssignal des dritten Signalwegs (32) mit einem Ausgangssignal des vierten Signalwegs (38) kombiniert wird.

31. Verfahren nach einem der Ansprüche 19 bis 30, **dadurch gekennzeichnet, dass** das Ausgangssignal des Analog-Digital-Wandlermoduls (46) über eine Kalibrierungseinheit (48) auf mindestens ein FIR-Filter (62, 78) rückgekoppelt wird.

32. Verfahren nach einem der Ansprüche 19 bis 31, **dadurch gekennzeichnet, dass** das Ausgangssignal des Analog-Digital-Wandlermoduls (46) über eine Kalibrierungseinheit (48) auf einen einstellbaren Verstärker (50) des Analog-Digital-Wandlermoduls (46) rückgekoppelt wird.

Fig.1

# Fig.2

EP 1 168 606 A2

# Fig.3

EP 1 168 606 A2

Fig.4

# Fig.5

# Fig.6

EP 1 168 606 A2

Fig.7

## Fig.8

EP 1 168 606 A2

# Fig.9

Fig.10

EP 1 168 606 A2

Fig.11

Fig.12

Fig.13